Europäisches Patentamt

European Patent Office

Office européen des brevets

(11) Publication number : **0 416 517 B1**

# EUROPEAN PATENT SPECIFICATION

(45) Date of publication of patent specification :
**10.05.95 Bulletin 95/19**

(51) Int. Cl.⁶ : **G03F 1/14**

(21) Application number : **90116929.2**

(22) Date of filing : **04.09.90**

(54) **Non-glare pellicle.**

(30) Priority : **06.09.89 US 403650**

(43) Date of publication of application :
**13.03.91 Bulletin 91/11**

(45) Publication of the grant of the patent :
**10.05.95 Bulletin 95/19**

(84) Designated Contracting States :
**AT CH DE FR GB IT LI NL**

(56) References cited :
**EP-A- 0 073 087**
**EP-A- 0 300 661**
**US-A- 4 657 805**

(73) Proprietor : **E.I. DU PONT DE NEMOURS AND COMPANY**
**1007 Market Street**
**Wilmington Delaware 19898 (US)**

(72) Inventor : **Gordon, Joseph S.**
**22 Dusinberry Road**
**Gardiner, New York 12525 (US)**
Inventor : **Golden, Kevin M.**
**76 Grove Street**
**Newburgh, New York 12550 (US)**

(74) Representative : **von Kreisler, Alek, Dipl.-Chem. et al**
**Patentanwälte**
**von Kreisler-Selting-Werner**
**Postfach 10 22 41**
**D-50462 Köln (DE)**

## Description

FIELD OF THE INVENTION

The invention relates to a pellicle which is used as a dust defocusing cover for a photomask or reticle. More specifically, the invention relates to a pellicle having at least one antireflective layer which enables the pellicle to transmit a greater percentage of incident light to the photomask or reticle.

BACKGROUND

Projection printing systems for forming an image on a light sensitive substrate or wafer are particularly suitable for effecting the exposure of photoresist-coated semiconductor wafers in the manufacture of integrated circuits. These systems normally include a photomask or reticle (hereinafter "mask") having a transparent substrate with a pattern of opaque and transparent areas formed on one surface thereof, an illumination system for directing a beam of radiant energy such as light or ultraviolet rays through the mask to the wafer, optical means for forming a focused image of the mask pattern on the wafer and a pellicle for maintaining the images of any dust particles out of focus on the surface of the mask.

The pellicle is a free-standing thin optical film supported on a frame. Normally, the frame is attached to the mask and the optical film stands away from the mask surface by a given distance. Dust particles which might otherwise settle on the mask and be projected onto the wafer, will settle on the pellicle instead and be defocused. Consequently, when pellicles are used in a conventional projection printing system, one or more dust particles will not affect the yield of a given wafer and yields can be significantly improved.

Ideally, pellicles should be invisible to the radiant energy of the projection printing system. That is, in order to produce clear, well-defined patterns, the optical film of the pellicle should transmit 100% (i.e reflect 0%) of the radiant energy used during the projection printing process.

In the past, single layer pellicles, typically made of nitrocellulose, have been used. With increasing miniaturization, the pattern elements have become smaller and smaller and the optical transmission of the pellicle films has become increasingly insufficient. In order to increase the optical transmission (reduce optical reflectiveness or glare) of pellicle films, and thus produce clear, well-defined patterns, multilayer pellicles with various anti-reflective coatings have been proposed.

For example, Japanese patent publication Kokai Patent No. 61-209449 discloses a nonglare multilayer pellicle having at least five layers wherein at least the two outermost layers consist of a fluorinated material selected from a TFE-VdF copolymer, a TFE-HFP-VdF terpolymer, a fluorine-containing acrylate or a fluorine-containing methacrylate. Published European Patent Application No. 224,985 discloses a pellicle having a core layer and a two-layer, organic, anti-reflective coating. The intermediate layer, which lies between the core layer and the outermost layer, consists of an aromatic polymer compound or a vinyl-group-containing compound. This intermediate layer cooperates with the outermost layer to form the anti-reflective coating. The outermost layer of the anti-reflective coating consists of a fluorocarbon compound. A product made by the Minnesota Mining and Manufacturing Company (3M), identified only as FC-721, is the only example of a fluorocarbon which is disclosed in this publication.

A multilayer pellicle having only the core layer and an anti-reflective coating has also been disclosed in the prior art. Japanese patent publication Kokai Patent No. 60-237450 discloses a multilayer pellicle having a nitrocellulose core layer and at least an outermost anti-reflective layer. The anti-reflective layer consists of either a silicon polymer, a TFE-VdF copolymer, or a terpolymer of TFE, VdF and HFP.

Although these prior art multilayer non-glare pellicles transmit more incident light than the corresponding single layer pellicles there is still room for improvement. For example, the five and seven layer pellicle films of Japanese patent publication Kokai Patent No. 61-209449 and published European Patent Application No. 224,985 take longer to make and are more difficult to make than a two or three layer film. On the other hand, the three layer films of Japanese patent publication Kokai Patent No. 60-237450, while more readily produced, transmit quite a varying percentage of incident light over the reported range of wavelengths, with the lowest percentage of transmission being only slightly more than the transmission of the uncoated core layer. Thus, there is still a need in the art for a pellicle film which transmits a high percentage of incident light and is readily produced.

Summary of the Invention

The invention is directed to a non-glare pellicle comprising a thin optical film which is tautly adhered to one edge of a closed support frame, said film comprising a core layer having an index of refraction of 1.32 to

2

1.80 and a thickness of 0.3 to 20 microns, and at least one antireflective layer comprising an amorphous copolymer of 30-99 mole % PDD with complementary amounts of at least one comonomer selected from the class consisting of the following compounds:

a) tetrafluoroethylene,

b) chlorotrifluoroethylene,

c) vinylidene fluoride,

d) hexafluoropropylene,

e) trifluoroethylene,

f) perfluoro(alkyl vinyl ethers) of the formula $CF_2=CFOR_F$, where $R_F$ is a normal perfluoroalkyl radical having 1-3 carbon atoms,

g) fluorovinyl ethers of the formula $CF_2=CFOQZ$, where Q is a perfluorinated alkylene radical containing 0-5 ether oxygen atoms, wherein the sum of the C and O atoms in Q is 2 to 10; and Z is a group selected from the class consisting of -COOR, $-SO_2F$, -CN, -COF, and $-OCH_3$, where R is a $C_1$-$C_4$ alkyl,

h) vinyl fluoride, and

i) (perfluoroalkyl)ethylene, $R_fCH=CH_2$, where $R_f$ is a $C_1$-$C_8$ normal perfluoroalkyl radical;

the glass transition temperature of the copolymer being at least 80°C,

the maximum mole percentage, $M_a...M_i$, of the comonomer in the copolymers being as follows:

a) for tetrafluoroethylene, $M_a=70$,

b) for chlorotrifluoroethylene, $M_b=70$,

c) for vinylidene fluoride, $M_c=70$,

d) for hexafluoropropylene, $M_d=15$,

e) for trifluoroethylene, $M_e=30$,

f) for $CF_2=CFOR_F$, $M_f=30$,

g) for $CF_2=CFOQZ$, $M_g=20$,

h) for vinyl fluoride, $M_h=70$, and

i) for $R_fCH=CH_2$, $M_i=10$;

and, in the case of copolymers with more than one comonomer, the amount of each comonomer being such that the sum, S, of the ratios of the mole percentages, $m_a...m_i$, to the corresponding maximum mole percentages, $M_a...M_i$ is no larger than 1, as shown below:

$$S = m_a/M_a + m_b/M_b + ... + m_i/M_i \leqq 1.$$

As used herein, the term "complementary" means that the mole percentage of PDD plus the mole percentages of all the above comonomers (a) through (i) present in the copolymer add together to 100%.

Brief Description of the Drawings

Figure 1 is a cross-sectional view of a photomask which has a pattern coated thereon and a pellicle secured thereto.

Figure 2 is an exploded cross-sectional view one embodiment of the invention in which the pellicle film in Fig. 1 taken across the section line 5-5 in Fig. 1 has an antireflective layer on both sides of the core layer.

Figure 2A is an exploded cross-sectional view of another embodiment of the invention in which the pellicle film in Fig. 1 taken across the section line 5-5 in Fig. 1 has an antireflective layer on the side of the core layer which is furthest from the pellicle frame.

Figure 2B is an exploded cross-sectional view of another embodiment of the invention in which the pellicle film in Fig. 1 taken across the section line 5-5 in Fig. 1 has an antireflective layer on the side of the core layer which is next to the pellicle frame.

Figure 3 is a graph of the fraction of light transmitted versus the wavelength of light, measured in nanometers, for the uncoated, 2.85 micron thick, nitrocellulose film of Reference Example A.

Figure 4 is a graph of the fraction of light transmitted versus the wavelength of light, measured in nanometers, for the 2.85 micron thick, nitrocellulose film having the single side antireflective layer of Example 1.

Figure 5 is a graph of the fraction of light transmitted versus the wavelength of light, measured in nanometers, for the 2.85 micron thick, nitrocellulose film having the two side antireflective layer of Example 2.

Figure 6 is a graph of the fraction of light transmitted versus the wavelength of light, measured in nanometers; for the 2.85 micron thick, nitrocellulose film having the two side antireflective layer of Example 3.

Figure 7 is a graph of the fraction of light transmitted versus the wavelength of light, measured in nanometers, for the 2.85 micron thick, nitrocellulose film having the two side antireflective layer of Example 4.

Figure 8 is a graph of the fraction of light transmitted versus the wavelength of light, measured in nanometers, for the uncoated, 2.1 micron thick, polysulfone film of Reference Example B.

Figure 9 is a graph of the fraction of light transmitted versus the wavelength of light, measured in nanometers, for the 2.1 micron thick, polysulfone film having the two side antireflective layer of Example 5.

Figure 10 is a graph of the fraction of light transmitted versus the wavelength of light, measured in nanometers, for the uncoated, 2.6 micron thick, polyethersulfone film of Reference Example C.

Figure 11 is a graph of the fraction of light transmitted versus the wavelength of light, measured in nanometers, for the 2.6 micron thick, polyethersulfone film having the two side antireflective layer of Example 6.

## Detailed Description of the Invention

## Antireflective layer

The amorphous copolymers of PDD which form the antireflective layer of the invention are disclosed in the U.S. Patent No. 4,754,099 and copending U.S. patent applications Serial No. 07/148,579 (Assignee's case no. 5206D) and _____(Assignee's case no. 5206E) each of which is incorporated herein by reference.

PDD is copolymerized with any one or more of the above-mentioned monomer) to produce an amorphous copolymer. All of the principal monomers used in this invention are known in the art. Copolymerization is carried out in the presence of a free radical generator at a temperature suitable for the initiator chosen. Well agitated pressure equipment and a nontelogenic solvent or diluent should be used, preferably one that has sufficient volatility to permit easy removal from the polymer.

These amorphous copolymers of PDD possess properties which are especially desirable for pellicle antireflection layers. Such properties include low absorption and dispersion of light in a broad range of wavelengths, low water absorption to reduce sagging, greater durability to permit repeated exposure, low refractive indices, low surface energy to reduce particulate adhesion and good chemical resistance to solvents and cleaning agents. In addition, these amorphous copolymers of PDD can be applied from a solvent which is incompatible with the underlying layers and which evaporates after application to produce a uniform anti-reflective layer. An incompatible solvent is one which does not dissolve or degrade any underlying layer. Such solvents include fluorocarbons such as Fluorinert® FC-40 Electronic Liquid, perfluoro trialkyl amines, Fluorinert® FC-75 Electronic Liquid, perfluoro(2-butyltetrahydrofuran) and Fluorinert® FC-77 Electronic Liquid, a fully fluorinated organic compound with a typical molecular weight range of 300-1000.

A preferred antireflective layer of the invention comprises an amorphous copolymer of 30-99 mole % PDD with a complementary amount of TFE and has an index of refraction in the range of 1.29 to 1.32. One particularly preferred antireflective layer comprise) an amorphous copolymer of 65 mole % PDD with 35 mole% TFE. Another particularly preferred antireflective layer comprises an amorphous copolymer of 90 mole% PDD with 10 mole % TFE.

In accordance with established principles of physics, the optimal thickness of the antireflective layer will vary depending on the refractive index of the antireflective layer material and the wavelength of energy that will be used. For example, a single transparent layer will reduce surface reflection if the refractive index of the layer is less than that of the substrate to which it is applied and the layer is of appropriate thickness. If the index of refraction of the layer material is exactly equal to the square root of that of the substrate, all surface reflection of light will be eliminated for that wavelength at which the product of refractive index times thickness is equal to one-quarter of the wavelength. At other wavelengths, the destructive interference between light reflected from top and bottom surfaces of the antireflection layer is not complete; but, nonetheless, there is a reduction in overall reflectiveness.

## Core layer

The core layer of the invention has an index of refraction of 1.32 to 1.80 and a thickness of 0.3 to 20 microns. Preferably, the core layer has an index of refraction of 1.51 and a thickness of 0.8 to 3.0 microns. Materials known in the art for making uncoated pellicles may be used as the core layer of the invention. These materials are capable of forming a free-standing, isolatable film of uniform thickness having a low level of particulates therein and low absorption of incident light. A film of this type is considered uniform if the thickness varies by less than 2 wavelengths of exposure frequency per inch. A "low level of particulates" means the film contains less than 20 visible particles and no particles greater than 20 microns. "Low absorption" means that less than 1% incident light is absorbed by the film.

Preferably, the core layer comprises a polymer selected from the group consisting of polycarbonates, polyacrylates, polyvinylbutyrates, polyethersulfones such as VICTREX® 4100P, polysulfones such as UDEL® 1700, and cellulose derivatives such as cellulose acetate, cellulose acetate butyrate or nitrocellulose. Most preferred are nitrocellulose.

## Support frame

The closed support frame of the invention may be in any shape and size suitable for attachment to a photo mask or reticle such that the pellicle film does not touch and the frame does not interfere with the work surface of the mask or reticle. Typically, the support frame is circular with a diameter of 1-6 inches, or square with sides of 1-6 inches. The material of the support frame should have high strength, a low tendency to attract dust, and a light weight. Hard plastics, and metals such as aluminum, and aluminum alloys are suitable materials for the support frame. An aluminum alloy, particularly machined, anodized aluminum, is preferred.

The pellicle film is tautly adhered to the closed support frame. Conventional glues and adhesives may be used to adhere the film to the frame provided the glue or adhesive does not contain a solvent for the core layer. Alternatively, the film may be adhered to the frame by heat press lamination. Preferably, a liquid, UV curable (i.e., curable upon exposure to ultra-violet light) adhesive, such as Magnacryl 2611 (Beacon Chemical Co.), is used in this invention.

## Pellicle

The PDD copolymers of this invention can be coated onto one or both sides of the core layer to form the pellicle film. This film is then tautly adhered to an edge of a closed support frame. If only one side of the core layer has an antireflective layer thereon, the side lacking the antireflective layer is preferably adhered to the support frame. If both sides of the pellicle film have an antireflective layer, either side may be adhered to the support frame.

The films of the invention can be produced by methods known in the art, e.g. Japanese patent publication Kokai Patent No. 60-237450.

In a preferred method, the core layer is produced by dissolving a core layer-forming material in a solvent and spin coating the solution onto a glass substrate. A solution suitable for spin coating should wet the substrate, form a uniform coating on the substrate and dry uniformly. After the solution is coated onto the spinning substrate, spinning is stopped and the coating is heated to evaporate solvent and form a uniform core layer. This uniform core layer is isolated from the substrate onto a lifting frame. The lifting frame is mounted onto a spin coater and the antireflective coating is formed on the core layer by spin coating a suitable solution of the PDD copolymer. A suitable spin coating solution of the PDD copolymer is formed by dissolving the amorphous PDD copolymer in a solvent which is incompatible with (i.e., will not dissolve or otherwise degrade) the core layer. If an anti-reflective layer is desired on both sides of the core layer, the lifting frame is raised off the spin coater, rotated 180° to expose the opposite side of the core layer, and remounted on the spin coater. The opposite side of the core layer is then coated with the PDD copolymer solution in the manner described above.

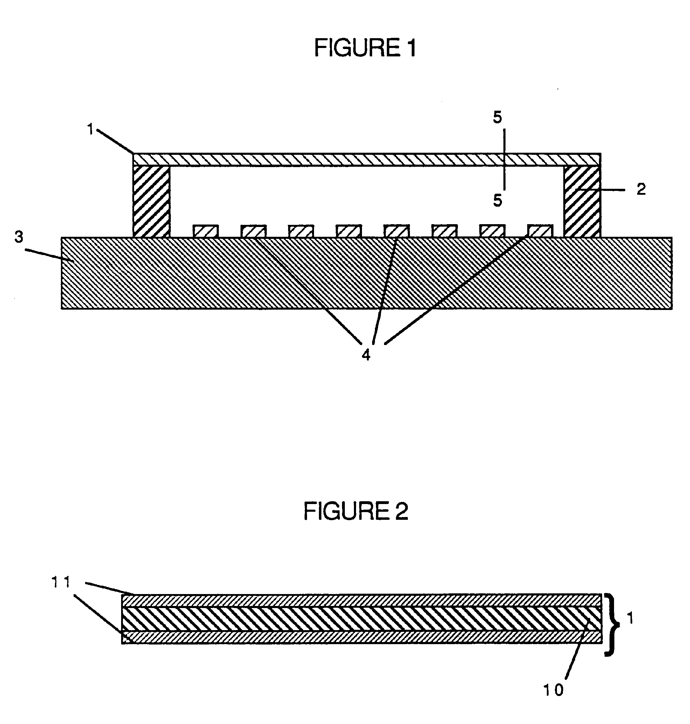

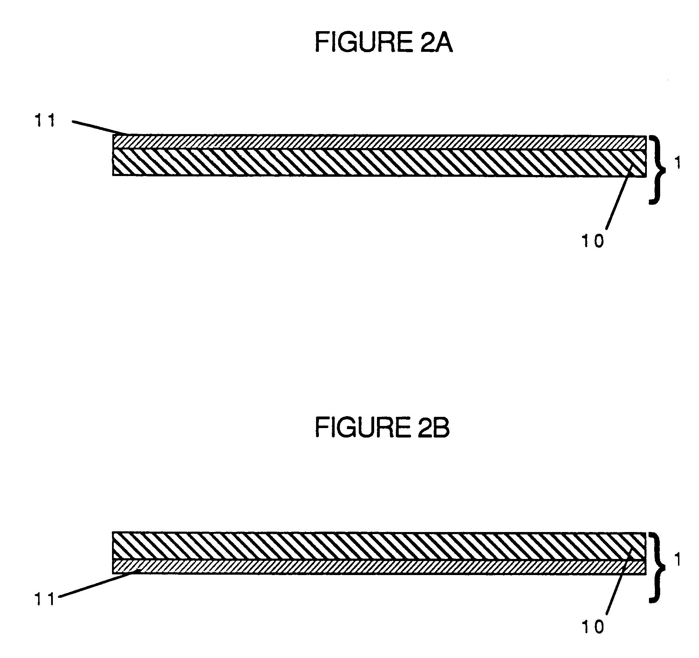

The coated core layer and the lifting frame to which it is attached are removed from the spin coater and heated to evaporate solvent. The resulting film is then appropriately adhered to a closed support frame by a suitable adhesive and extends tautly across the support frame, which is smaller than the lifting frame. The side of the support frame opposite the adhered film is secured to a mask surface, the pellicle film suspended above the pattern on the surface of the mask. Figure 1 illustrates such a pellicized mask. The mask 3 is transparent and typically, composed of silica. A pattern 4 is coated on the upper surface of mask 3. This pattern is encompassed by support frame 2 and covered by pellicle film 1. The pellicle film 1 comprises a core layer 10 having an antireflective layer 11 on both sides thereof, as shown in Figure 2, an antireflective layer 11 on only the top side thereof, as shown in Figure 2A, or an antireflective layer 11 on only the bottom side thereof, as shown in Figure 2B. Radiant energy is projected from a source above the pellicle film through the film, pattern and mask onto a photoresist coated wafer in order to produce integrated circuits.

Although the foregoing discussion and the following examples are directed primarily to thin optical films having only a core layer and a PDD copolymer antireflective layer on one or both sides thereof, the invention is not so limited. The ordinary artisan will recognize that additional layers such as antistatic layers and cooperating antireflective layers, may also be part of the thin optical film of this invention. Conventional methods such as spin-coating may be used to produce these films having additional layers.

## EXAMPLES

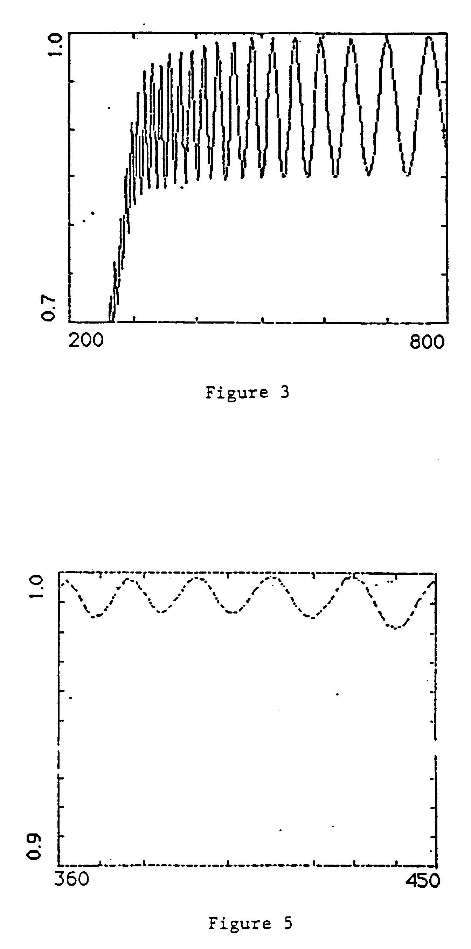

In the following examples, the preferred method for making a pellicle film which was described above was used with the indicated materials and conditions. Figures 3-12 are spectral transmission graphs for the respective examples. The horizontal axis of each graph is wavelength, in nanometers, of a standard high pressure mercury lamp and the vertical axis is the fraction of light transmitted through the respective pellicle film.

Reference Example A

A nitrocellulose solution (19.2% wt. nitrocellulose wet with 30% wt. n-butanol, dissolved in 81% wt. n-butyl acetate) was spin coated on a glass substrate and heated to 100°C for 5 minutes to evaporate solvent. The resulting uniform, 2.85 micron thick, nitrocellulose film transmitted about 82% to about 99% of incident light at wavelengths of 300 to 800 nanometers, as shown in Figure 3. Further examination of Figure 3 shows that at wavelengths of 350 to 460 nanometers, the amount of incident light transmitted by this film varied from about 83% to about 98%.

Example 1

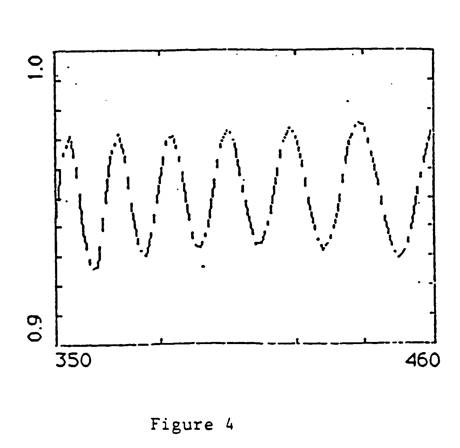

The nitrocellulose solution of Reference Example A was spin coated and heated to 100°C for 5 minutes to evaporate solvent. A lifting frame was attached to the uniform, 2.85 micron thick nitrocellulose layer by an adhesive and the layer removed from the spin coater substrate. The lifting frame was then mounted onto a spin coater. A solution of 1.25 % by weight of a 65 mole % PDD with 35 mole % TFE copolymer dissolved in Fluorinert® FC-40 Electronic Liquid, perfluoro trialkyl amines, was filtered through a 0.2 micron syringe disc filter and dispensed onto the nitrocellulose layer. Approximately 2.5 cubic centimeters of the filtered copolymer solution was coated onto the nitrocellulose layer. The coated nitrocellulose layer was rotated for 2.5 minutes, the final rotation rate being 1200 RPM. The nitrocellulose layer coated on one side with a copolymer of 65 mole % PDD and 35 mole % TFE was heated to 100°C for 5 minutes. The resulting film transmitted greater than 92% of incident light at wavelengths of 350 to 460 nanometers, as shown in Figure 4.

Example 2

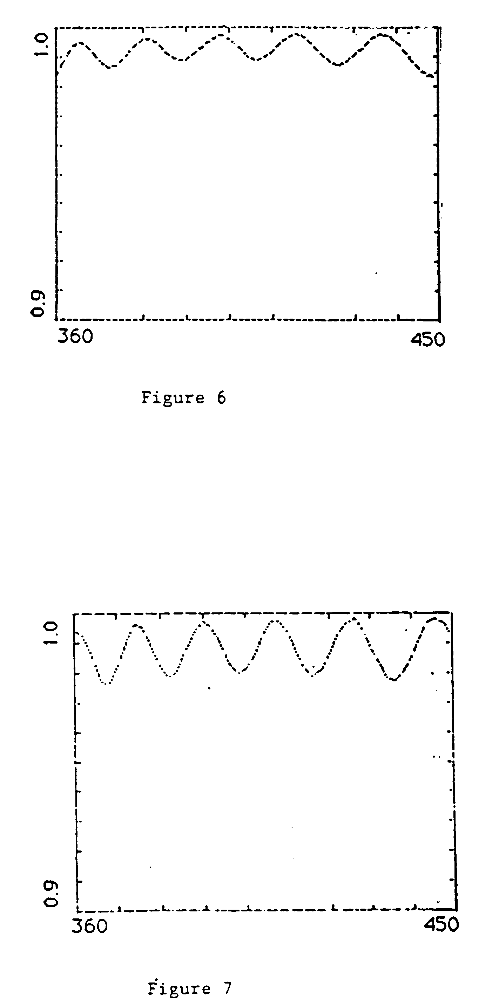

The nitrocellulose solution of Reference Example A was spin coated and heated to 100°C for 5 minutes to evaporate solvent. A lifting frame was attached to the uniform nitrocellulose layer by a flexible adhesive tape and the layer was removed from the spin coater substrate. The lifting frame was then mounted onto a spin coater. A solution of 1.25 % by weight of a 65 mole % PDD with 35 mole % TFE copolymer dissolved in Fluorinert® FC-40 Electronic Liquid, perfluoro trialkyl amines, was filtered through a 0.2 micron syringe disc filter and dispensed onto the nitrocellulose layer. Approximately 2.5 cubic centimeters of the filtered copolymer solution was coated onto the nitrocellulose layer. The coated nitrocellulose layer was rotated for 2.5 minutes, the final rotation rate being 1200 RPM. After the first side of the nitrocellulose layer was coated with said copolymer solution, the opposite side of the nitrocellulose layer was coated by rotating the lifting frame 180° and repeating the process. The nitrocellulose layer coated on both sides with a copolymer of 65 mole % PDD and 35 mole % TEE was heated to 100°C for 5 minutes. The resulting film transmitted greater than 98% of incident light at wavelengths of 360 to 450 nanometers, as shown in Figure 5.

Example 3

The nitrocellulose solution of Reference Example A was spin coated and heated to 100°C for 5 minutes to evaporate solvent. A lifting frame was attached to the uniform, 2.85 micron thick nitrocellulose layer by an adhesive and the layer was removed from the spin coater substrate. The lifting frame was then mounted onto a spin coater. A solution of 1.00 % by weight of a 90 mole % PDD with 10 mole % TFE copolymer dissolved in Fluorinert® FC-40 Electronic Liquid, perfluoro trialkyl amines, was dispensed onto the nitrocellulose layer. Approximately 2.5 cubic centimeters of the copolymer solution was coated onto the nitrocellulose layer. The coated nitrocellulose layer was rotated for 2.5 minutes, the final rotation rate being 1200 RPM. After the first side of the nitrocellulose layer was coated with said copolymer solution, the opposite side of the nitrocellulose layer was coated by rotating the lifting frame 180° and repeating the process. The nitrocellulose layer coated on both sides with a copolymer of 90 mole % PDD and 10 mole % TFE was heated to 100°C for 10 minutes. The resulting film transmitted greater than 98% of incident light at wavelengths of 360 to 450 nanometers, as shown in Figure 6.

Example 4

The nitrocellulose solution of Reference Example A was spin coated and heated to 100°C for 5 minutes to evaporate solvent. A lifting frame was attached to the uniform, 2.85 micron thick nitrocellulose layer by an adhesive and the layer was removed from the spin coater substrate. The lifting frame was then mounted onto a spin coater. A solution of 1.00% by weight of a 30 mole % PDD with 70 mole % TFE copolymer dissolved in 9.0 % by weight Fluorinert® FC-75 Electronic Liquid, perfluoro(2-butyltetrahydrofuran), and 90.0 % by weight Fluorinert® FC-40 Electronic Liquid, perfluoro trialkyl amines, was dispensed onto the nitrocellulose layer. Approximately 10 cubic centimeters of the copolymer solution was coated onto the nitrocellulose layer. The coated nitrocellulose layer was rotated at a final rotation rate of 1735 RPM. After the first side of the nitrocellulose layer was coated with said copolymer solution, the opposite side of the nitrocellulose layer was coated by rotating the lifting frame 180° and repeating the process. The resulting film transmitted greater than 97% of incident light at wavelengths of 360 to 450 nanometers, as shown in Figure 7.

Reference Example B

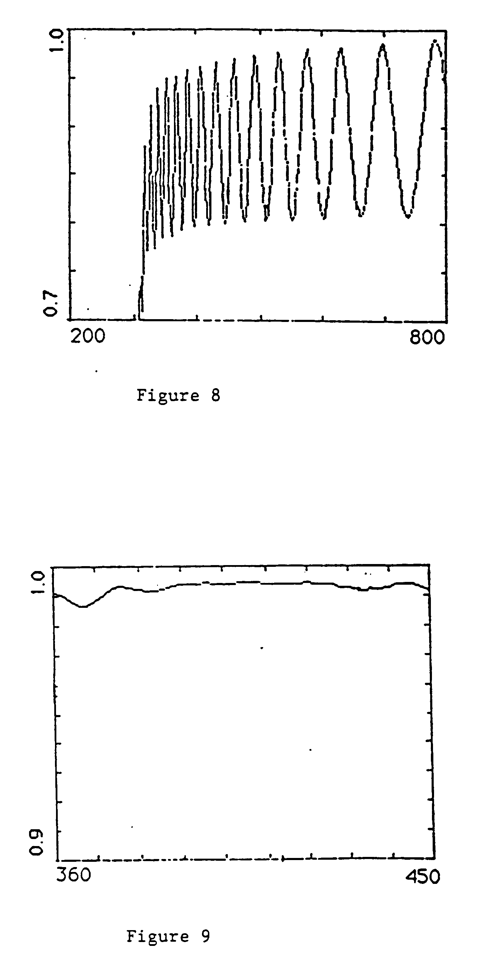

A polysulfone solution (12% by weight UDEL® 1700 polysulfone dissolved in ethylbenzoate) was filtered through a 0.45 micron filter and dispensed onto a glass spin coater substrate which was rotated for 10 minutes with a final rotation rate of 450 RPM. The coated substrate was heated to 200°C for 5 minutes to evaporate solvent. The resulting uniform, 2.1 micron thick, polysulfone film transmitted from less than 70% to about 99% of incident light at wavelengths of 300 to 800 nanometers, as shown in Figure 8. Further examination of Figure 8 shows that at wavelengths of 350 to 460 nanometers, the amount of incident light transmitted by this film varied from about 83% to about 97%.

Example 5

The polysulfone solution of Reference Example B was spin coated and heated to 200°C for 5 minutes to evaporate solvent. A lifting frame was attached to the uniform, 2.1 micron thick polysulfone layer by an adhesive and the layer was removed from the spin coater substrate under water. The lifting frame was then mounted onto a spin coater. A solution of 1.25 % by weight of a 65 mole % PDD with 35 mole % TFE copolymer dissolved in Fluorinert® FC-40 Electronic Liquid, perfluoro trialkyl amines, was dispensed onto the polysulfone layer. The coated polysulfone layer was rotated at a final rotation rate of 1500 RPM. After the first side of the polysulfone layer was coated with said copolymer solution, the opposite side of the polysulfone layer was coated by rotating the lifting frame 180° and repeating the process. The resulting film transmitted greater than 98% of incident light at wavelengths of 360 to 450 nanometers, as shown in Figure 9.

Reference Example C

A polyethersulfone solution (20% by weight VICTREX® 4100P polyethersulfone dissolved in n-methyl pyrrolidinone was dispensed onto a glass spin coater substrate which was rotated for minutes with a final rotation rate of 1200 RPM. The coated substrate was heated to 200°C. for 10 minutes to evaporate solvent. The resulting uniform, 2.6 micron thick, polyethersulfone film transmitted from less than 70% to about 99% of incident light at wavelengths of 300 to 800 nanometers, as shown in Figure 10. Further examination of Figure 10 shows that at wavelengths of 350 to 460 nanometers, the amount of incident light transmitted by this film varied from about 74% to about 98%.

Example 6

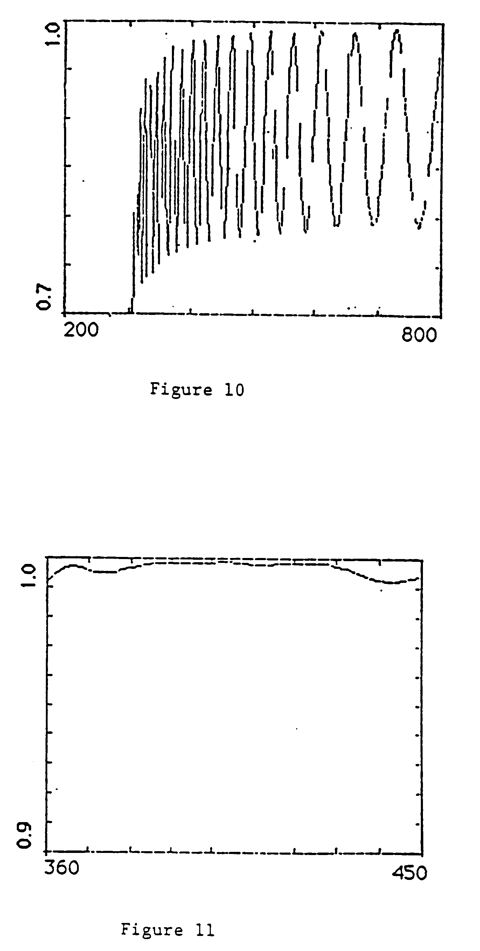

The polyethersulfone solution of Reference Example C was spin coated and heated to 200°C for 10 minutes to evaporate solvent. A lifting frame was attached to the uniform, 2.6 micron thick polysulfone layer by an adhesive and the layer was removed from the spin coater substrate. The lifting frame was then mounted onto a spin coater. A solution of 1.25 % by weight of a 65 mole % PDD with 35 mole % TFE copolymer dissolved in Fluorinert® FC-40 Electronic Liquid, perfluoro trialkyl amines, was dispensed onto the polyethersulfone layer. The coated polyethersulfone layer was rotated at a final rotation rate of 1200 RPM. After the first side of the polyethersulfone layer was coated with said copolymer solution, the opposite side of the polyethersulfone layer was coated by rotating the lifting frame 180° and repeating the process. The resulting film transmitted greater than 98% of incident light at wavelengths of 360 to 450 nanometers, as shown in Figure 11.

LIST OF ABBREVIATIONS

TFE=    tetrafluoroethylene
VdF=    vinylidene fluoride
HFP=    hexafluoropropylene
PDD=    perfluoro-2,2-dimethyl-1,3-dioxole

EP 0 416 517 B1

LIST OF TRADEMARKS

VICTREX® is a trademark of ICI Americas, Wilmington, DE
UDEL® is a trademark of Union Carbide Corp., Morristown, NJ
ZONYL® is a trademark of E. I. du Pont de Nemours and Company, Inc., Wilmington, DE
FLUORINERT® is a trademark of 3M Co., St. Paul, MN

**Claims**

1. A non-glare pellicle comprising a thin optical film which is tautly adhered to one edge of a closed support frame, said film comprising a core layer having an index of refraction of 1.32 to 1.80 and a thickness of 0.3 to 20 microns, and at least one antireflective layer comprising an amorphous copolymer of 30-99 mole % of perfluoro-2,2-dimethyl-1,3-dioxole with complementary amounts of at least one comonomer selected from the class consisting of the following compounds:
   a) tetrafluoroethylene,
   b) chlorotrifluoroethylene,
   c) vinylidene fluoride,
   d) hexafluoropropylene,
   e) trifluoroethylene,
   f) perfluoro(alkyl vinyl ethers) of the formula $CF_2=CFOR_F$, where $R_F$ is a normal perfluoroalkyl radical having 1-3 carbon atoms,
   g) fluorovinyl ethers of the formula $CF_2=CFOQZ$, where Q is a perfluorinated alkylene radical containing 0-5 ether oxygen atoms, wherein the sum of the C and O atoms in Q is 2 to 10; and Z is a group selected from the class consisting of -COOR, $-SO_2F$, -CN, -COF, and $-OCH_3$, where R is a $C_1$-$C_4$ alkyl,
   h) vinyl fluoride, and
   i) (perfluoroalkyl)ethylene, $R_fCH=CH_2$, where $R_f$ is a $C_1$-$C_8$ normal perfluoroalkyl radical;
      the glass transition temperature of the copolymer being at least 80°C,
      the maximum mole percentage, $M_a...M_i$, of the comonomer in the copolymers being as follows:
   a) for tetrafluoroethylene, $M_a=70$,
   b) for chlorotrifluoroethylene, $M_b$ 70,
   c) for vinylidene fluoride, $M_c=70$,
   d) for hexafluoropropylene, $M_d=15$,
   e) for trifluoroethylene $M_e=30$,
   f) for $CF_2=CFOR_F$, $M_f=30$,
   g) for $CF_2=CFOQZ$, $M_g=20$,
   h) for vinyl fluoride, $M_h=70$, and
   i) for $R_fCH=CH_2$, $M_i=10$;
      and, in the case of copolymers with more than one comonomer, the amount of each comonomer being such that the sum, S, of the ratios of the mole percentages, $m_a . . . m_i$, to the corresponding maximum mole percentages, $M_a . . . M_i$ is no larger than 1, as shown below:
      $$S = m_a/M_a + m_b/M_b + ... + m_i/M_i \leq 1.$$

2. The non-glare pellicle of Claim 1 wherein said antireflective layer(s) comprise(s) an amorphous copolymer of 30-99 mole % perfluoro-2,2-dimethyl-1,3-dioxole with complementary amounts of tetrafluoroethylene.

3. The non-glare pellicle of Claim 2 wherein said core layer comprises a polymer selected from the group consisting of polycarbonates, polyacrylates, polyvinylbutyrates, polyethersulfones, polysulfones and cellulose derivatives.

4. The non-glare pellicle of Claim 3 wherein said core layer comprises nitrocellulose.

5. The non-glare pellicle of Claim 4 wherein said film transmits greater than 97% of incident light in the band of 350 nanometers to 460 nanometers.

6. The non-glare pellicle of Claim 5 wherein said film comprises a core layer and an antireflective layer on one side of the core layer.

7. The non-glare pellicle of Claim 5 wherein said film comprises a core layer and an antireflective layer on

8

both sides of the core layer.

8. The non-glare pellicle of Claim 6 or 7 wherein said antireflective layer(s) comprise(s) an amorphous copolymer of 65-90 mole % perfluoro-2,2-dimethyl-1,3-dioxole with 35-10 mole % tetrafluoroethylene.

**Patentansprüche**

1. Nicht reflektierende Filmabdeckung, die einen dünnen optischen Film umfaßt, der straff an einen Rand eines geschlossenen Trägerrahmens geklebt ist, wobei der Film folgendes umfaßt: eine Kernschicht mit einem Brechungsindex von 1,32 bis 1,80 und einer Dicke von 0,3 bis 20 μm und wenigstens eine antireflektierende Schicht, umfassend ein amorphes Copolymer mit 30-99 Mol-% Perfluor-2,2-dimethyl-1,3-dioxol mit komplementären Mengen wenigstens eines Comonomers, das aus der Klasse ausgewählt ist, die aus den folgenden Verbindungen besteht:

   a) Tetrafluorethylen,
   b) Chlortrifluorethylen,
   c) Vinylidenfluorid,
   d) Hexafluorpropylen,
   e) Trifluorethylen,
   f) Perfluoralkylvinylether der Formel $CF_2=CFOR_F$, wobei $R_F$ ein normaler Perfluoralkylrest mit 1-3 Kohlenstoffatomen ist,
   g) Fluorvinylether der Formel $CF_2=CFOQZ$, wobei Q ein perfluorierter Alkylenrest mit 0-5 Ethersauerstoffatomen ist, wobei die Summe der C- und O- Atome in Q 2 bis 10 beträgt, und Z eine Gruppe ist, die aus der Klasse ausgewählt wird, die aus $-COOR$, $-SO_2F$, $-CN$, $-COF$ und $-OCH_3$ besteht, wobei R ein $C_1-C_4$-Alkyl ist,
   h) Vinylfluorid und
   i) (Perfluoralkyl)ethylen, $R_fCH=CH_2$, wobei $R_f$ ein $n-C_1-C_8$-Perfluoralkylrest ist; wobei die Glasübergangstemperatur des Copolymers wenigstens 80°C beträgt,

   wobei der maximale Molprozentwert $M_a...M_i$ des Comonomers in den Copolymeren wie folgt ist:

   a) für Tetrafluorethylen, $M_a = 70$,
   b) für Chlortrifluorethylen, $M_b = 70$,
   c) für Vinylidenfluorid, $M_c = 70$,
   d) für Hexafluorpropylen, $M_d = 15$,
   e) für Trifluorethylen, $M_e = 30$,
   f) für $CF_2=CFOR_F$, $M_f = 30$,
   g) für $CF_2=CFOQZ$, $M_g = 20$,
   h) für Vinylfluorid, $M_h = 70$ und
   i) für $R_fCH=CH_2$, $M_i = 10$;

   und wobei im Falle von Copolymeren mit mehr als einem Comonomer die Menge jedes Comonomers so ist, daß die Summe S der Verhältnisse der Molprozente $m_a...m_i$ zu den entsprechenden maximalen Molprozenten $M_a...M_i$ nicht größer ist als 1, wie unten gezeigt:

   $$S = m_a/M_a + m_b/M_b + ... + m_i/M_i \leqq 1.$$

2. Nicht reflektierende Filmabdeckung gemäß Anspruch 1, wobei die antireflektierende(n) Schicht(en) ein amorphes Copolymer von 30-99 Mol-% Perfluor-2,2-dimethyl-1,3-dioxol mit komplementären Mengen Tetrafluorethylen umfaßt bzw. umfassen.

3. Nicht reflektierende Filmabdeckung gemäß Anspruch 2, wobei die Kernschicht ein Polymer umfaßt, das aus der Gruppe ausgewählt ist, die aus Polycarbonaten, Polyacrylaten, Polyvinylbutyraten, Polyethersulfonen, Polysulfonen und Cellulosederivaten besteht.

4. Nicht reflektierende Filmabdeckung gemäß Anspruch 3, wobei die Kernschicht Nitrocellulose umfaßt.

5. Nicht reflektierende Filmabdeckung gemäß Anspruch 4, wobei der Film mehr als 97% des einfallenden Lichts im Bereich von 350 nm bis 460 nm durchläßt.

6. Nicht reflektierende Filmabdeckung gemäß Anspruch 5, wobei der Film eine Kernschicht und eine antireflektierende Schicht auf einer Seite der Kernschicht umfaßt.

7. Nicht reflektierende Filmabdeckung gemäß Anspruch 5, wobei der Film eine Kernschicht und eine antireflektierende Schicht auf beiden Seiten der Kernschicht umfaßt.

8. Nicht reflektierende Filmabdeckung gemäß Anspruch 6 oder 7, wobei die antireflektierende(n) Schicht(en) ein amorphes Copolymer von 65-90 Mol-% Perfluor-2,2-dimethyl-1,3-dioxol mit 35-10 Mol-% Tetrafluorethylen umfaßt bzw. umfassen.

**Revendications**

1. Une pellicule antireflets comprenant un film optique mince qui est fermement collé à un bord d'un cadre de support fermé, ledit film comprenant une couche de noyau ayant un indice de réfraction de 1,32 à 1,80 et une épaisseur de 0,3 à 20 μm, et au moins une couche anti-réfléchissante constituée d'un copolymère amorphe comprenant de 30 à 99% en moles de perfluoro-2,2-diméthyl-1,3-dioxole et des quantités complémentaires d'au moins un comonomère choisi dans la classe constituée par les composés suivants:
   a) tétrafluoroéthylène,
   b) chlorotrifluoroéthylène,
   c) fluorure de vinylidène,
   d) hexafluoropropylène,
   e) trifluoroéthylène,
   f) perfluoro (alkyl vinyl éthers) de formule $CF_2= CFORf$, où Rf est un groupe n-perfluoroalkyle ayant de 1 à 3 atomes de carbone,
   g) éthers de fluorovinyle de formule $CF_2= CFOQZ$, où Q est un groupe alkylène perfluoré contenant de 0 à 5 atomes d'oxygène d'éther, dans lequel la somme des atomes de C et de O dans Q est de 2 à 10; et Z est un groupe choisi parmi la classe consistant en $-COOR, -SO_2F, -CN, -COF$, et $-OCH_3$, où R est un groupe alkyle en C1-C4,
   h) fluorure de vinyle, et
   i) (perfluoroalkyl) éthylène, $RfCH= CH_2$, où Rf est un groupe n-perfluoroalkyle en C1-C8;
      la température de transition vitreuse du copolymère étant d'au moins 80°C,
      les pourcentages maximum en moles, $M_a...M_i$, du comonomère dans les copolymères étant les suivants:
   a) pour le tétrafluoroéthylène, $M_a = 70$,
   b) pour le chlorotrifluoroéthylène, $M_b = 70$,
   c) pour le fluorure de vinylidène, $M_c = 70$,
   d) pour l'hexafluoropropylène, $M_d = 15$,
   e) pour le trifluoroéthylène, $M_e = 30$,
   f) pour $CF_2=CFORf$, $M_f =30$,
   g) pour $CF_2=CFOQZ$, $M_g = 20$,
   h) pour le fluorure de vinyle, $M_h = 70$, et
   i) pour $RfCH=CH_2$, $M_i = 10$;
      et, dans le cas de copolymères préparés à partir de plus d'un comonomère, la quantité de chaque comonomère étant telle que la somme, S, des rapports des pourcentages en moles, $m_a.... m_i$, par rapport aux pourcentages correspondants maximum en moles, $M_a...M_i$ ne dépasse pas 1, comme cela est représenté ci-dessous:

$$S = m_a/M_a + m_b/M_b + ... + m_i/M_i \leq 1.$$

2. La pellicule antireflets selon la revendication 1, dans laquelle ladite ou lesdites couche(s) anti-réfléchissante(s) compren(d) (nent) un copolymère amorphe de 30 à 99% en moles de perfluoro-2,2-diméthyl-1,3-dioxole avec des quantités complémentaires de tétrafluoro-éthylène.

3. La pellicule antireflets selon la revendication 2, dans laquelle ladite couche de noyau comprend un polymère choisi parmi le groupe consistant en polycarbonates, polyacrylates, polyvinyl-butyrates, polyéthersulfones, polysulfones et dérivés de cellulose.

4. La pellicule antireflets selon la revendication 3, dans laquelle ladite couche de noyau comprend de la nitrocellulose.

5. La pellicule antireflets selon la revendication 4, dans laquelle ledit film transmet plus de 97% de la lumière incidente dans la bande de 350 nanomètres à 460 nanomètres.

6. Pellicule antireflets selon la revendication 5, dans lequel ledit film comprend une couche de noyau et une couche anti-réfléchissante sur une face de la couche de noyau.

7. La pellicule antireflets selon la revendication 5, dans laquelle ledit film comprend une couche de noyau et une couche anti-réfléchissante sur les deux faces de la couche de noyau.

8. La pellicule antireflets selon la revendication 6 ou 7, dans laquelle ladite ou lesdites couche(s) anti-réfléchissante(s) compren(d) (nent) un copolymère amorphe de 65 à 90% en moles de perfluoro-2,2-diméthyl-1,3-dioxole avec 35 à 10% en moles de tétrafluoroéthylène.

# FIGURE 1

# FIGURE 2

# FIGURE 2A

# FIGURE 2B

Figure 3

Figure 5

Figure 4

Figure 6

Figure 7

16

Figure 8

Figure 9

Figure 10

Figure 11